(19) **Europäisches Patentamt / European Patent Office / Office européen des brevets**

(11) **EP 3 995 843 B1**

(12) # EUROPEAN PATENT SPECIFICATION

(45) Date of publication and mention
of the grant of the patent:
**16.10.2024 Bulletin 2024/42**

(21) Application number: **20206273.3**

(22) Date of filing: **06.11.2020**

(51) International Patent Classification (IPC):
***G01R 31/34*** *(2020.01)*

(52) Cooperative Patent Classification (CPC):
**G01R 31/343**

(54) **EFFICIENT MONITORING OF CONDITION AND WORKING TIMES FOR ASSETS USED IN AN INTERMITTENT MANNER**

EFFIZIENTE ÜBERWACHUNG DES ZUSTANDS UND DER ARBEITSZEITEN VON INTERMITTIEREND GENUTZTEN ANLAGEN

SURVEILLANCE EFFICACE DE L'ÉTAT ET DES TEMPS DE TRAVAIL DES ACTIFS UTILISÉS DE MANIÈRE INTERMITTENTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**11.05.2022 Bulletin 2022/19**

(73) Proprietor: **ABB Schweiz AG**
**5400 Baden (CH)**

(72) Inventors:
• **ORIOL, Manuel**
**8005 Zürich (CH)**

• **HUJBAND, Pallavi**
**560048 Bangalore (IN)**
• **ORMAN, Maciej**
**32-052 Radziszow, Malopolskie (PL)**

(74) Representative: **Zimmermann & Partner Patentanwälte mbB**
**Postfach 330 920**
**80069 München (DE)**

(56) References cited:
**WO-A1-2018/189602    WO-A1-2020/168379**
**US-A- 6 124 692**

**Description**

**TECHNICAL FIELD**

The present disclosure relates to methods for monitoring an intermittently running rotating machine by a battery-powered monitoring device. The present disclosure also relates to a battery-powered monitoring device.

**BACKGROUND**

A rotating machine, like other industrial assets, needs to be monitored for a plurality of purposes including but not limited to performance monitoring, stress and ageing monitoring, surveillance, etc.

The monitoring may need to take place in environments where it is not possible or not convenient to power a monitoring device with an external energy source.

When powering a monitoring device for monitoring a rotating machine by a battery that cannot be conveniently replaced or recharged, the power consumption becomes critical.

A high frequency continuous monitoring of the rotating machine quickly consumes the electrical energy of the battery.

A low frequency continuous monitoring is too coarse and does not collect enough data.

WO2018/189602A1 describes a method for changing an operational state of a condition monitoring device of an electrical machine. WO 2020/168379A1 describes power monitoring. US6124692A describes a method and apparatus for reducing electrical power consumption in a machine monitor.

If the rotating machine is operated intermittently there is the need to adapt the monitoring to the different periods when the rotating machine is running or not running, while improving the energy efficiency without losing accuracy.

Furthermore, there is the need to reduce the overall power consumption of a battery-powered monitoring device for monitoring a rotating machine, while maintaining a sufficient quality of the monitoring.

**SUMMARY**

One embodiment of the present disclosure provides a method for monitoring an intermittently running rotating machine by a battery-powered monitoring device, the monitoring device comprising a battery, at least one sensor unit powered by the battery, and a control unit powered by the battery, the method comprising:

- Carrying out by the sensor unit, a low-power measurement of an operation status quantity $\omega$ indicative of an operation status of the rotating machine;
- Evaluating, by the control unit, a high-power measurement condition $\mu(\omega, \tau)$ indicating whether or not a high-power measurement is to be carried out, wherein the evaluating is based on the measured operation status quantity $\omega$ and on a time duration $\tau$ since a previous high-power measurement; and
- in case of the evaluated high-power measurement condition $\mu(\omega, \tau)$ being found to be met, carrying out, by the sensor unit, the high-power measurement, thereby obtaining monitoring data $\delta$ from the sensor unit, wherein

the low-power measurement and the evaluating steps are carried out repeatedly.

Another embodiment of the present disclosure provides a battery-powered monitoring device for monitoring an intermittently running rotating machine, the monitoring device comprising:

- a battery,

- a sensor unit powered by the battery,

- a control unit powered by the battery;

wherein the battery-powered monitoring device is configured to monitor the intermittently running rotating machine by carrying out method of the present disclosure.

**BRIEF DESCRIPTION OF DRAWINGS**

FIG. 1 shows a method for monitoring an intermittently running rotating machine by a battery-powered monitoring device.

FIG. 2 shows a flowchart describing a method for monitoring an intermittently running rotating machine by a battery-powered monitoring device according to embodiments of the present disclosure.

FIG. 3 shows a flowchart describing a method for monitoring an intermittently running rotating machine by a battery-powered monitoring device according to some embodiments of the present disclosure

## DETAILED DESCRIPTION OF EMBODIMENTS

As used herein an asset is a physical system, for example a rotating machine, that is designed to fulfill a specification. For example, the rotating machine may be an electric motor designed to convert electric energy into mechanical energy. The rotating machine may for example conversely be an electric generator that converts mechanical energy into electrical energy.

A rotating machine may not be used in a continuous manner. For example, a motor may be only used intermittently when a torque is needed and/or when a force has to be applied to rotate and/or move an object, for example for imparting a rotational speed to a shaft. Time intervals in which the motor provide a high torque and/or a high rotational speed alternate with time intervals in which the motor is switched off or only provides very low torque and/or rotational speed.

Therefore, the stress and the deterioration/ageing of the rotating machine, may not occur continuously in time, but be distributed more in some time intervals than in other time intervals.

Furthermore, the stress and the deterioration/ageing of the rotating machine may be a function of the actual operating conditions of the rotating machine.

While a motor that is switched off is not subjected to stress and/or may only minimally deteriorate, a motor that is providing maximum torque and/or speed may be subjected to a maximal stress, deteriorating and ageing significantly while the stress persists.

Depending on the history of stresses and operating conditions of the rotating machine, a remaining expected lifetime for the rotating machine can be estimated and/or the time of the next maintenance of the rotating machine may be affected.

Conversely a running motor that runs at moderately constant speed may experience only very limited stress and deterioration.

To keep track of the stress conditions of the rotating machine it is necessary to monitor the rotating machine. For example, the history of motor speed, motor torque, motor temperature may determine an expected remaining lifetime of the motor and/or an expected time interval for the next maintenance.

A monitoring of the rotating machine may provide a plurality of benefits, not only related to the estimation of remaining lifetime and/or to the determination of a next maintenance instant.

Monitoring data may be used to improve an existing design of the rotating machine obtaining an improved/optimized design or at least a candidate for an improved/optimized design, the performance of which improved/optimized design may be subsequently evaluated monitoring a new generation of the rotating machine realized based on the improved/optimized design. Therefore, in an optimization loop monitoring data allows an effective optimization of the design of the rotating machine, allowing to determine the performance of various alternative designs when exploring the design space.

The quality of a design may be for example a function of energy efficiency, reliability, resilience, life expectancy of the rotating machine.

Each performance or quality metric must be evaluated based on appropriate monitoring data that may be related for example to a temperature of the rotating machine and/or to heat dissipated by the rotating machine and/or to an overall active lifetime of the rotating machine under predefined operating conditions and/or to the functioning of the rotating machine after a fault and/or to the ability of the rotating machine to detect and handle a fault, etc. Further data may be useful to reconstruct the life/operation history of the rotating machine. For example, logging periods when the rotating machine was turned on or off, logging a state of the rotating machine and/or parameters of the rotating machine may be needed to reconstruct and/or analyze the operation of the rotating machine.

The state of the rotating machine may include a rotational speed, a power consumption, a torque, etc.

In order to monitor the rotating machine a monitoring device with at least one sensor unit is needed, the sensor unit including sensors to collect the monitoring data $\delta$ indicative of a condition/state of the rotating machine. The monitoring data may include quantitative measurements about the rotating machine. Therefore, monitoring implies measuring at least one quantity of the rotating machine

The measurements performed by the sensor unit of the monitoring device that collect monitoring data $\delta$ indicative of a condition/state of the rotating machine require a source of energy.

Providing a battery-powered monitoring device has the advantage that the monitoring device can be deployed/installed also when an external energy source for the monitoring device is not available.

The battery-powered monitoring device may be installed together with the battery in a casing, that may for example be an airtight and/or watertight casing and then be placed in the proximity of the rotating machine to monitor. In this manner, the monitoring device may autonomously perform a long-term monitoring of the rotating machine measuring and obtaining monitoring data $\delta$ of the rotating machine.

The data $\delta$ may include any suitable quantity of interest related to the rotating machine like e.g. temperature, speed, magnetic field, vibration, acoustic signals, electromagnetic signals, power or current consumption, etc. Therefore, the sensor unit may include sensors for temperature, speed, magnetic field, vibration, acoustic and electromagnetic measurements etc. configured to measure the monitoring data $\delta$ of the rotating machine. Herein, a measurement is understood as the operation of the sensor unit leading to the output of a defined operational quantity such as temperature, speed, magnetic field, vibration, acoustic and electromagnetic intensity.

The monitoring device may include a memory to store measurement results and a clock to provide timestamps that may used to label the measured data and/or to track state changes of the rotating machine.

The monitoring device may send the measured monitoring data $\delta$ over a network or communication channel, e.g. over a wireless network or a wireless communication channel, to allow an evaluation of the measured data with or without timestamps labeling the data.

Alternatively or in addition, the monitoring device may store the measured monitoring data $\delta$ in a long-term storage unit and/or in a long-term memory, e.g. a nonvolatile memory, and/or on a physical support and the long-term stored monitoring data $\delta$ may be read out when the rotating device ages and/or when the battery of the monitoring device is low or empty.

Although a battery-powered monitoring device provides several advantages in terms of autonomy, easiness and flexibility of deploy, the battery forms also an energetic bottleneck.

The battery only provides limited energy and this energy together with the power consumption of the monitoring device determines the operational lifetime of the monitoring device assuming that the battery cannot or should not be replaced and/or recharged.

To reduce the power consumption of the monitoring device and to increase therefore the duration of the battery and the operational lifetime of the monitoring device it is beneficial to reduce the average frequency of measurements of the monitoring data $\delta$.

Conversely a high overall average frequency of measurements is needed to capture the monitoring data $\delta$ sufficiently often to describe the history of the operation of the rotating machine with the desired accuracy.

A tradeoff arises therefore between reducing the average frequency of measurements of the monitoring data $\delta$ to increase the lifetime/operational time of the battery and increasing the average frequency of measurements of the monitoring data $\delta$ to collect more monitoring data of the rotating machine to allow a more detailed monitoring.

When the rotating machine is operated intermittently, it is beneficial to avoid the collection of monitoring data $\delta$ during time intervals where the rotating machine is either not operating or the operation of the rotating machine is below a threshold. For example, when a rotational speed of the rotating machine is below a threshold, then a monitoring may not be necessary and the collection of the monitoring data can be avoided, therefore reducing the power consumption from the battery of the monitoring device.

To know when the rotating device is operating or not, e.g. when a threshold is exceeded or not, a measurement is beneficial to measure an operation status quantity $\omega$ indicative of an operation status of the rotating machine.

Based at least in part on the measured operation status quantity $\omega$, it is possible to evaluate if a measurement of the monitoring data $\delta$ is required or not.

The operational status quantity $\omega$ indicative of an operation status of the rotating machine may be measured with the at least one sensor unit of the battery-powered monitoring device with a low-power measurement.

Herein, the low-power measurement is carried out with less energy than the high-power measurement described herein. The low-power measurement may be a measurement of only a subset of the operational quantities measured by the high-power measurement. Herein, the energy is the energy consumed for the respective (low-power or high-power) measurement and may be given in units of Wh. In embodiments, the energy $P_{low}$ consumed by the low-power measurement and the energy $P_{high}$ consumed by the high-power measurement may satisfy the relation $P_{low} / P_{high} < 0.5$, or $P_{low} / P_{high} < 0.2$, or even $P_{low} / P_{high} < 0.1$.

The operational status quantity $\omega$ therefore does not provide the full information provided by the monitoring data $\delta$ about a state/condition of the rotating machine, but only a limited amount of data (less than the monitoring data $\delta$) allowing to determine if the rotating machine is operating or not. The reduced amount of information provided by the measurement of the operation status quantity $\omega$ requires only a reduced power consumption from the battery of the monitoring device. Therefore, the measurement of the operation status quantity $\omega$ is a low-power measurement compared to the measurement of the monitoring data $\delta$ that therefor forms a high-power measurement.

The operational status quantity $\omega$ may be measured regularly at a high frequency with low-power measurements, whereas a high-power measurement of monitoring data $\delta$ is carried out only if the status quantity $\omega$ is indicative of an operation status of the rotating machine and if additional requirements are met, like for example if the time duration since a previous high-power measurement of the monitoring data $\delta$ exceeds a threshold.

According to embodiments, the monitoring device, and in particular the sensor unit and/or the control unit are powered by the battery, and in particular are powered by the battery as the dominant energy source; they may powered by only the battery.

According to embodiments, the sensor unit of the monitoring device is powered by the battery and carries out a low-power measurement of an operation status quantity $\omega$ indicative of an operation status of the rotating machine.

A control unit of the monitoring device, the control unit powered by the battery of the monitoring device, then evaluates a condition $\mu(\omega, \tau)$ indicting whether or not a high-power measurement is to be carried out our not. Said evaluation is based on the measured operation status quantity $\omega$ and on a time duration $\tau$ since a previous high-power measurement. If a previous high-power measurement did not occur, then $\tau$ may be considered as infinite oo.

The operation status quantity $\omega$ may involve also some data processing foe example for determining key performance indicators.

The high power measurement condition may be for example

$$\mu(\omega, \tau) = \left( (\omega > \omega_0) \bigwedge (\tau > \tau_0) \right)$$

where the operation status quantity $\omega$ is a scalar quantity indicative for example of a vibrational energy, or of a sound intensity, or of a magnetic field intensity. $\omega_0$ indicates an operation status threshold that is also a scalar and similarly $\tau_0$ indicates a time threshold. The operator $\wedge$ indicates logic conjunction (and). Therefore $\mu(\omega, \tau)$ evaluates to true if and only if the operation status quantity $\omega$ exceeds the operation status threshold $\omega_0$ and the time duration $\tau$ since the previous high-power measurement exceeds the time threshold $\tau_0$.

In alternative embodiments the operation status quantity $\omega$ may be a vector including a plurality of measurements, e.g. of vibrational energy and sound intensity and magnetic field intensity. In said embodiments the high power measurement condition $\mu(\omega, \tau)$ may for example be

$$\mu(\omega, \tau) = \left( (\|\omega\| > \omega_0) \bigwedge (\tau > \tau_0) \right)$$

Where $\|\omega\|$ indicates a suitable norm of the vector $\omega$ describing the operation status quantity, for example the norm may be the Euclidean norm or the maximum norm.

In yet other embodiments for example

$$\mu(\omega, \tau) = \left( (\|\omega - \omega_{off}\| > \omega_0) \bigwedge (\tau > \tau_0) \right)$$

where $\omega_{off}$ is a vector indicating an offset. A scalar is considered herein as a vector having only one component.

The offset may for example specify a vector indicating quantities that are still indicative of the rotating machine being not operational. For example a first component of the offset $\omega_{off}$ may specify a low-level vibration that may be present even when the rotating machine is not operational or not fully operational, a second component of the offset $\omega_{off}$ may indicate a low-level noise level that may be present even when the rotating machine is not operational or not fully operational, a third component may similarly specify a magnetic field intensity that may be present even when the rotating machine is not operational or not fully operational etc.

Because the relational operator > returns a Boolean value and the conjunction $\wedge$ receives Boolean values returning a Boolean value, the power measurement condition $\mu(\omega, \tau)$ will be Boolean, i.e. evaluating to either true or false.

The low-power measurement of the operation status quantity co is carried out repeatedly, but it only requires a small amount of power from the battery. The repeated measurements may be carried out based on a clock at regular intervals. In some embodiments the repeated measurements may also be triggered asynchronously directly by the sensor unit.

In some embodiments, the sensor unit may be configured to operate permanently in a low-power mode in order to asynchronously detect the operating status quantity exceeding an operating status quantity threshold.

The power measurement condition $\mu(\omega, \tau)$ is then also evaluated whenever the operation status quantity $\omega$ is measured and only it he power measurement condition evaluates to true, the high-power measurement of the monitoring data is carried out. In particular a high power measurement condition is avoided whenever the rotating machine is not running or is not sufficiently running or whenever a previous high-power measurement of the monitoring data was carried out recently, i.e. within a time interval of duration $\tau_0$.

Advantages of the present disclosure becomes now understandable.

The power consumption of the battery is optimized, while the accuracy is maintained.

High-power measurements are avoided when the running rotating machine is not in an operation status. High-power measurements are avoided when a high-power measurement was carried out recently, i.e. within a time interval of duration $\tau_0$ including the present time instant.

An asynchronous start of the rotating machine is not missed, given that the low-power measurements of the operation status quantity are carried out repeatedly.

A running rotating machine is not monitored too often, given that a monitoring only takes place when the time duration $\tau$ since a previous high-power measurement exceeds a time threshold $\tau_0$.

In such a way the battery duration is maximized, while the monitoring can still be carried out with sufficient accuracy, avoiding unnecessary measurement and an unnecessary high-power consumption in view of the low-power measurements of the operational status quantity.

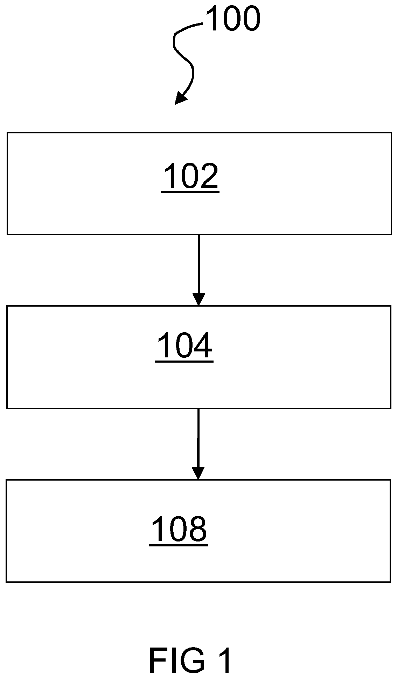

FIG. 1 illustrates a method 100 for monitoring an intermittently running rotating machine by a battery-powered monitoring device according to embodiments of the present disclosure. The monitoring device includes a battery, at least one sensor unit, and a control unit. The method includes: carrying out (102), by the sensor unit powered by the battery, a low-power measurement of an operation status quantity $\omega$ indicative of an operation status of the rotating machine; evaluating (104), by the control unit powered by the battery, a high-power measurement condition $\mu(\omega, \tau)$ indicating whether or not a high-power measurement is to be carried out, wherein the evaluating is based on the measured operation status quantity $\omega$ and on the time duration $\tau$ since a previous high-power measurement; and in case of the evaluated high-power measurement condition $\mu(\omega, \tau)$ being found to be met, carrying out (108), by the sensor unit powered by the battery, the high-power measurement, thereby obtaining monitoring data $\delta$ from the sensor unit, wherein the low-power measurement and the evaluating steps are carried out repeatedly.

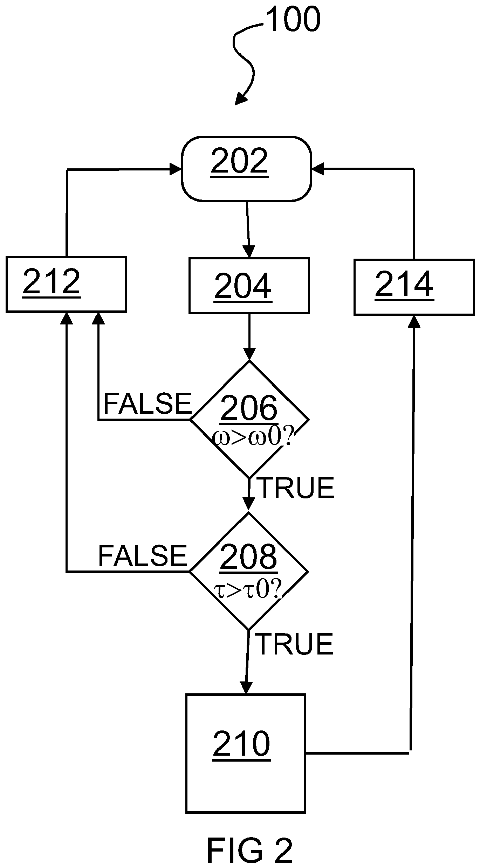

FIG.2 further illustrated a flowchart of a method (100) for monitoring an intermittently running rotating machine by a battery-powered monitoring device according to some embodiments of the present disclosure.

A control unit powered by the battery of the battery-powered monitoring device wakes up (202) and gathers (204) low-power sensor input for a short amount of time from the at least one sensor unit of the monitoring device. The low-power sensor input gathered (204) by the control unit corresponds to the operation status quantity $\omega$ obtained with a low-power measurement.

The control unit then evaluates (206) if the sensor input is sufficient to detect an operating condition (on condition) of the rotating machine. The evaluation (206) corresponds for example to the evaluation of ($\omega > \omega_0$), i.e. of the evaluation of a condition indicating if the operation status quantity $\omega$ exceeds operation status threshold $\omega_0$.

If this is not the case the control unit sleeps (212) for a predetermined amount of time, for example for 2.5 minutes, waking up (202) again afterwards and continuing the execution gathering (204) again sensor data as previously described, continuing according to the flowchart.

Otherwise, i.e. if ($\omega > \omega_0$) does hold, the control unit continues the execution evaluating (208) if the last measurement was taken more than a predetermined time duration ago.

Therefore, the evaluation (208) corresponds to the evaluation of ($\tau > \tau_0$), i.e. to the evaluation if the time duration since the last high-power measurement is above a time threshold.

If this condition is met then the control unit proceeds carrying out (210) by the sensor unit powered by the battery the high-power measurement, thereby obtaining monitoring data $\delta$ from the sensor unit.

Afterwards the control unit sleeps (214) for a period of time, for example for 60 minutes, waking up (202) again repeating the previously described steps illustrated by the flowchart.

We observe that the evaluation (206) together with the evaluation (208) corresponds to the evaluation (104) of the high-power measurement condition $\mu(\omega, \tau)$.

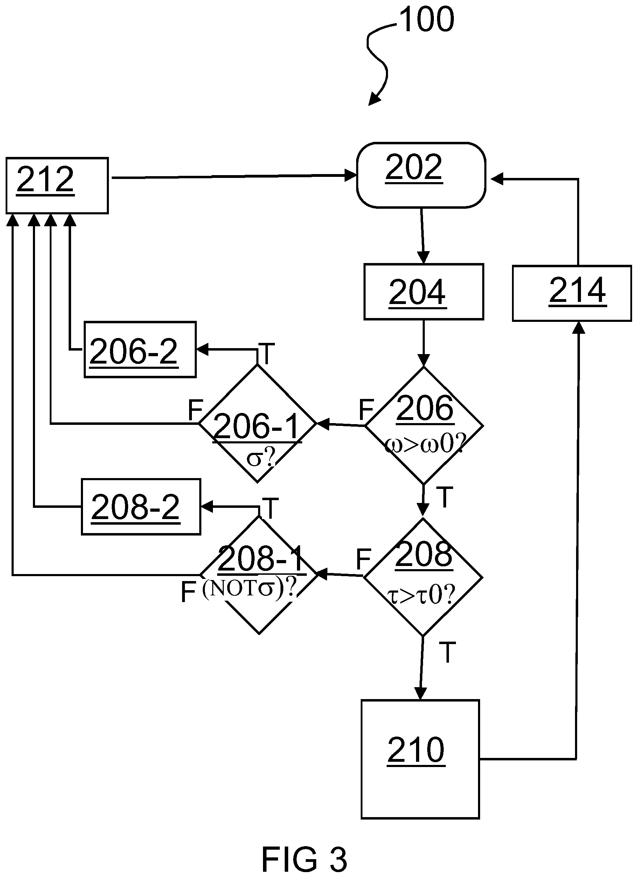

FIG. 3 illustrates a flowchart describing a method for monitoring an intermittently running rotating machine by a battery-powered monitoring device according to some embodiments of the present disclosure.

The algorithm illustrated by the flowchart of FIG. 3 is analogous to the algorithm illustrated by the flowchart of FIG. 2 with some differences. The algorithm relative to the flowchart of FIG. 3 further logs state changes of the rotating machine using a global state variable $\sigma$.

According to embodiments illustrated by the flowchart of FIG. 3, when the control unit evaluates (206) if ($\omega > \omega_0$), i.e. when the control unit evaluates if the operation status quantity is above an operation status quantity threshold, in the case that said evaluation results in the condition not holding, i.e. in the case that $(\omega > \omega_0) \Leftrightarrow$ *false*, then the execution continues checking (206-1) if the state variable $\sigma$ is true. If the state variable $\sigma$ is true, then the state variable $\sigma$ is set (206-2) to false, to account for the fact that the operation status quantity is not above the operation status quantity threshold, before the execution sleeps (212). In addition a timestamp is generated based on a clock signal and the updated value of the state variable $\sigma$ is recorded together with the timestamp, appending an ordered pair containing the updated value of the state variable and the timestamp to a sequence stored in a memory of the device. Otherwise if the state variable $\sigma$ is already false when checking (206-1) the value of the state variable, then no update is needed and the execution proceeds sleeping (212) for a predetermined amount of time, e.g. 2.5 minutes and continuing as described for the flowchart of FIG. 2.

Similarly when evaluating (208) if the last measurement was taken more than a predetermined time duration ago, i.e. when evaluating (208) $(\tau > \tau_0)$, in the case that said evaluation (208) results in the condition not holding, i.e. in the case that $(\tau > \tau_0) \Leftrightarrow$ *false* the execution continues checking (208-1) if the state variable $\sigma$ is false or, equivalently, checking if $\neg\sigma$ is true, $\neg$ indicating the NOT unary operator.

If this is the case, the state variable $\sigma$ is set (208-2) to true, to take into account that the operation status quantity was found above the operation status quantity threshold, i.e. to account for $(\omega > \omega_0) \Leftrightarrow$ *true.* In addition, a timestamp is generated based on a clock signal and the updated value of the state variable $\sigma$ is recorded together with the timestamp, appending an ordered pair containing the updated value of the state variable and the timestamp to a sequence stored in a memory of the device. Then the execution continues sleeping (212) for a predefined amount of time, e.g. for 2.5 minutes. Otherwise if the state variable $\sigma$ is already true (i.e. if $\neg\sigma$ is already false) when checking (208-1) the value of the state variable, then no update is needed and the execution continues sleeping (212) and further repeating the previously described steps.

In both algorithms corresponding to the flowcharts of FIG.2 and FIG.3 when the control unit proceeds carrying out (210) the high-power measurement a plurality of further action may be performed. For example, when carrying out (210) the high-power measurement, the state variable $\sigma$ may be updated. A timestamp is generated based on a clock signal and the updated value of the state variable $\sigma$ is recorded together with the timestamp, appending an ordered pair containing the updated value of the state variable and the timestamp to a sequence stored in a memory of the device.

The state variable $\sigma$ is therefore indicative of an operation status of the rotating device.

A plurality of other parameters may be further recorded together with related timestamps when carrying out (210) the high-power measurement.

In some embodiments a total running time (total on time) is computed based on recorded time-stamps collected during the high-power measurements and the low-power measurements. The total running time may be used to estimate a remaining lifetime of the rotating machine or a next-maintenance time.

After the high-power measurement is performed, the execution sleeps (214) for a predetermined amount of time. The time duration of the sleep (214) may be for example 60 minutes, or for example 2.5 minutes. In non-limiting examples, the time duration of the sleep may for example be at least 1 minute and/or at most 300 minutes. In non-limiting examples, a time duration of the sleep (short amount of time) may for example be at least 1 minute or at least 2 minutes, and/or at most 15 minutes or at most 10 minutes. In other embodiments, a time duration of the sleep (long amount of time) may for example be at least 15 minutes or at least 30 minutes, and/or at most 300 minutes or at most 120 minutes. A shorter sleep time is beneficial to keep track and record the state changes of the rotating machine with a high sample rate.

Furthermore, in alternative embodiments, the wake up (206) may also result from an asynchronous triggering of some sensor of the battery-powered monitoring device, running in background in a low-power mode.

Monitoring of assets, like rotating machines, used in an intermittent manner is difficult to perform in an efficient manner. The main trade-off is between performing constant monitoring (which would typically drain the battery) and not enough monitoring which would make the monitoring process ineffective. The present invention solves that issue by proposing an algorithm where short low-power measurements are performed at regular intervals so that it can be decided whether to make a full high-power measurement. The present disclosure both spares the battery and allows to make measurements at times where the rotating machine has the highest chances of working.

Monitoring at very small intervals is very battery consuming for battery-based sensor systems. In such devices, making measurements at the times where the asset is being used is of utmost importance. In the case assets are working continuously a simple time-based schedule is enough, but in case of intermittent use, triggering measurements at the right time is important. Deciding on what the right time is however not easy to decide, because the asset working is typically triggered by external events, asynchronously.

The present disclosure relates to measuring sensor input (or base it on crossing a threshold) to approximate whether the monitored asset is working and then decide when to trigger measurements. The sensor input can include, but is not limited to: temperature measurements, acceleration, variation of the magnetic field, acoustic measurements, current consumption.

According to an embodiment of the present disclosure the monitoring device sleeps for a short amount of time, for example for 2.5 minutes, and then either wakes up on a clock signal or on an asynchronous signal generated by at least one sensor configured to sense in a low-power mode an operational status quantity of the rotating machine. The asynchronous signal may be indicative of at least a potential operation status of the rotation machine. On wake up the device measures with a low-power measurement the operational status quantity $\omega$ with sufficient accuracy for a short amount of time. Based on the operational status quantity and if some time threshold has been reached, for example 60 minutes, then a full measurement is launched and all sensors are fully read and further post processing may occur for determining for example key performance indicators.

In this way costly high-power measurements are not triggered every single time a detection of the operation of the asset has to be carried out. Conversely when the asset is working, full sensor input is measured at regular intervals sufficiently capturing the data necessary for an adequate monitoring.

According to an embodiment of the present disclosure, further time measurements are carried out. For example, when performing the low-power and/or the high-power measurements a logging is carried out to log an operation state of the asset. The logging may be based on timestamps recording detected state changes of the rotating machine.

In some embodiments, several sensor monitoring assets of the monitoring device automatically synchronize if there is a downtime of more than one hour.

In the following different embodiments of the present disclosure are described in more detail.

Embodiments of the present disclosure disclose a method (100) for monitoring an intermittently running rotating machine by a battery-powered monitoring device, the monitoring device comprising a battery, at least one sensor unit, and a control unit, the method comprising: carrying out (102, 204), by the sensor unit powered by the battery, a low-power measurement of an operation status quantity $\omega$ indicative of an operation status of the rotating machine; evaluating (104, 206, 208), by the control unit powered by the battery, a high-power measurement condition $\mu(\omega, \tau)$ indicating whether or not a high-power measurement is to be carried out, wherein the evaluating is based on the measured operation status quantity $\omega$ and on the time duration $\tau$ since a previous high-power measurement; and in case of the evaluated high-power measurement condition $\mu(\omega, \tau)$ being found to be met, carrying out (108, 210), by the sensor unit powered by the battery, the high-power measurement, thereby obtaining monitoring data $\delta$ from the sensor unit, wherein the low-power measurement and the evaluating steps are carried out repeatedly.

In some embodiments, the sensor unit comprises one or more vibration sensors and/or one or more acoustic sensors and/or one or more magnetometers.

In some embodiments, the low-power measurement of an operation status quantity $\omega$ allows to determine if the rotation machine is running or not, wherein the low-power measurement is carried out with less energy than the high-power measurement.

In some embodiments, the high power measurement condition $\mu(\omega, \tau)$ is met when the operation status quantity $\omega$ indicative of the running operation status of the rotating machine exceeds an operation status threshold, and the time duration $\tau$ since a previous high-power measurement exceeds a time threshold.

In some embodiments, at least one threshold selected from the operation status threshold and the time threshold is a variable threshold, and wherein the method comprises determining a validation operating status based on the high-power measurement condition $\mu(\omega, \tau)$, and adaptively determining the variable threshold based on the determined validation operating status.

The threshold adaption can be performed in particular by the control unit when carrying out (210) the high-power measurement, basing the threshold adaption on a comparison of the measured values during the high-power measurement with the values obtained gathering (204) the low-power sensor input. The threshold adaption may result in adapted values of the operation status threshold $\omega_0$ and/or the time threshold $\tau_0$ and/or in some embodiments the offset $\omega_{off}$.

The adaption may in particular reduce the frequency of outcomes for which the high-power measurement condition $\mu(\omega, \tau)$ evaluates to true, while the subsequently measured monitoring data $\delta$ does not confirm a running condition of the rotating machine, while still maintaining adequately low threshold to not miss (i.e. with a probability of missing that is below a probability threshold) an actual running condition of the rotating machine when evaluating the high-power measurement condition.

In some embodiments, the low-power measurement is carried out repeatedly at a high repetition rate and the high-power measurement condition $\mu(\omega, \tau)$ is met only when the time duration $\tau$ since a previous high-power measurement exceeds a time threshold that is greater than an average period of the high repetition rate, in particular at least greater by a factor of at least 2, preferably of at least 5, more preferably of at least 10.

In some embodiments the time intervals between two consecutive low-power measurements are smaller than the time threshold.

In some embodiments, the low-power measurement and/or the high-power measurement further comprises a time measurement and the low-power measurement and/or the high-power measurement is logged together with a time stamp based on the time measurement, wherein the logging preferably further comprises a logging of the operation status of the rotating machine, in particular of a running operating status of the rotating machine to allow a tracking of operation status changes of the rotating machine and/or a monitoring of the ageing of the rotating machine and/or a monitoring of stresses of the rotating machine, in particular wherein a logging of the operation status of the rotating machine is carried out when the operating status of the rotating machine changes.

In some embodiments, a maintenance condition of the rotating machine is determined based on the monitoring data $\delta$ and/or the operations status quantity $\omega$ obtained during different high-power and/or low power measurements, in particular wherein the monitoring data $\delta$ and/or the operation status quantity $\omega$ include timestamps and a total runtime of the rotating machine is determined based at least in part on the timestamps.

Some embodiments disclose a battery-powered monitoring device for monitoring an intermittently running rotating machine, the monitoring device comprising:

- a battery,

- a sensor unit powered by the battery,

- a control unit powered by the battery;

wherein the battery-powered monitoring device is configured to monitor the intermittently running rotating machine by carrying out the methods of the present disclosure.

In some embodiments, the battery-powered monitoring device is integrated with the intermittently running rotating machine and the battery-powered monitoring device is configured for a long-term monitoring of the intermittently running rotating machine without battery replacement or recharging.

In some embodiments, the battery-powered monitoring device further includes a sender or a network unit configured to transmit data, in particular data obtained by the low-power measurement and/or the high-power measurement and/or timestamps related to the measurements, in particular wherein the data is transmitted over a network or a communication channel to a computer or to a cloud computing system.

In some embodiments, the battery-powered monitoring device further includes a case enclosing the battery-powered monitoring device, in particular a watertight and/or airtight case.

In some embodiments, the battery-powered monitoring device is further configured to be remotely controlled and put into a standby mode, in particular when the intermittently running rotating machine is not running for a prolonged time period.

In some embodiments, the battery-powered monitoring device is further configured to communicate a low battery condition.

In some embodiments, a local memory of the battery-powered monitoring device stores the measured values and the timestamps and can be read-out.

The present disclosure provides a highly energy efficient battery-powered monitoring device and a method for monitoring an intermittently running rotating machine by the battery-powered monitoring device. The improved methods prevent unnecessary measurements and selectively use low-power and high-power measurements to minimize the total amount of power used, providing a highly energy-efficient monitoring while maintaining an overall high amount of data that is collected about the running rotating machine.

**Claims**

1. A method (100) for monitoring an intermittently running rotating machine by a battery-powered monitoring device, the monitoring device comprising a battery, at least one sensor unit powered by the battery, and a control unit powered by the battery, the method comprising:

    - Carrying out (102, 204), by the sensor unit, a low-power measurement of an operation status quantity $\omega$ indicative of an operation status of the rotating machine;
    - Evaluating (104, 206, 208), by the control unit, a high-power measurement condition $\mu(\omega, \tau)$ indicating whether or not a high-power measurement is to be carried out, wherein the evaluating is based on the measured operation status quantity $\omega$ and on a time duration $\tau$ since a previous high-power measurement; and
    - in case of the evaluated high-power measurement condition $\mu(\omega, \tau)$ being found to be met, carrying out (108, 210), by the sensor unit, the high-power measurement, thereby obtaining monitoring data $\delta$ from the sensor unit, wherein

    the low-power measurement and the evaluating steps are carried out repeatedly.

2. The method of claim 1, wherein the sensor unit comprises one or more vibration sensors and/or one or more acoustic sensors and/or one or more magnetometers.

3. The method of any preceding claims, wherein the low-power measurement of an operation status quantity $\omega$ allows to determine if the rotation machine is running or not.

4. The method of any preceding claims, wherein the high power measurement condition $\mu(\omega,\tau)$ is met when the operation status quantity $\omega$ indicative of the running operation status of the rotating machine exceeds an operation status threshold, and/or the time duration $\tau$ since a previous high-power measurement exceeds a time threshold.

5. The method of claim 4, wherein at least one threshold selected from the operation status threshold and the time threshold is a variable threshold, and wherein the method comprises determining a validation operating status based on the high-power measurement condition $\mu(\omega,\tau)$, and adaptively determining the variable threshold based on the determined validation operating status.

6. The method of any preceding claims wherein the low-power measurement is carried out repeatedly at a high repetition rate and the high-power measurement condition $\mu(\omega,\tau)$ is met only when the time duration $\tau$ since a previous high-power measurement exceeds a time threshold that is greater than an average period of the high repetition rate, in particular at least greater by a factor of at least 2, preferably of at least 5, more preferably of at least 10.

7. The method of claim 4 or of claim 5 wherein time intervals between two consecutive low-power measurements are smaller than the time threshold.

8. The method of any preceding claims wherein the low-power measurement and/or the high-power measurement further comprises a time measurement and the low-power measurement and/or the high-power measurement is logged together with a time stamp based on the time measurement, wherein the logging preferably further comprises a logging of the operation status of the rotating machine, in particular of a running operating status of the rotating machine to allow a tracking of operation status changes of the rotating machine and/or a monitoring of the ageing of the rotating machine and/or a monitoring of stresses of the rotating machine, in particular wherein a logging of the operation status of the rotating machine is carried out when the operating status of the rotating machine changes.

9. The method of any of the preceding claims, wherein a maintenance condition of the rotating machine is determined based on the monitoring data $\delta$ and/or the operations status quantity $\omega$ obtained during different high-power and/or low power measurements, in particular wherein the monitoring data $\delta$ and/or the operation status quantity $\omega$ include timestamps and a total runtime of the rotating machine is determined based at least in part on the timestamps.

10. A battery-powered monitoring device for monitoring an intermittently running rotating machine, the monitoring device comprising:

   - a battery,
   - a sensor unit powered by the battery,
   - a control unit powered by the battery;

   wherein the battery-powered monitoring device is configured to monitor the intermittently running rotating machine by carrying out the method of any of claims from 1 to 9.

11. The battery-powered monitoring device of claim 10, wherein the battery-powered monitoring device is integrated with the intermittently running rotating machine and the battery-powered monitoring device is configured for a long-term monitoring of the intermittently running rotating machine without battery replacement or recharging.

12. The battery-powered monitoring device of any of claims from 10 to 11 further comprising a sender or a network unit configured to transmit data, in particular data obtained by the low-power measurement and/or the high-power measurement and/or timestamps related to the measurements, in particular wherein the data is transmitted over a network or a communication channel to a computer or to a cloud computing system.

13. The battery-powered monitoring device of any of claims from 10 to 12, further comprising a case enclosing the battery-powered monitoring device, in particular a watertight and/or airtight case.

14. The battery-powered monitoring device of any of claims from 10 to 13 further configured to be remotely controlled and put into a standby mode, in particular when the intermittently running rotating machine is not running for a prolonged time period.

15. The battery-powered monitoring device of any of claims from 10 to 14 further configured to communicate a low battery condition.

**Patentansprüche**

1. Verfahren (100) zur Überwachung einer intermittierend laufenden rotierenden Maschine durch eine batteriebetriebene Überwachungsvorrichtung, wobei die Überwachungsvorrichtung eine Batterie, mindestens eine von der Batterie gespeiste Sensoreinheit und eine von der Batterie gespeiste Steuereinheit umfasst, wobei das Verfahren umfasst:

 - Durchführen (102, 204) einer Niederleistungsmessung einer Betriebszustandsgröße $\omega$ durch die Sensoreinheit, die einen Betriebszustand der rotierenden Maschine anzeigt;
 - Beurteilen (104, 206, 208) einer Hochleistungsmessbedingung $\mu(\omega, \tau)$ durch die Steuereinheit, die anzeigt, ob eine Hochleistungsmessung durchgeführt werden soll oder nicht, wobei das Beurteilen auf der gemessenen Betriebszustandsgröße $\omega$ und auf einer Zeitdauer $\tau$ seit einer vorherigen Hochleistungsmessung basiert; und,
 - falls festgestellt wird, dass die beurteilte Hochleistungsmessbedingung $\mu(\omega, \tau)$ erfüllt wird, Durchführen (108, 210) der Hochleistungsmessung durch die Sensoreinheit, um dadurch Überwachungsdaten $\delta$ von der Sensoreinheit zu erhalten, wobei

 die Niederleistungsmessung und die Beurteilungsschritte wiederholt ausgeführt werden.

2. Verfahren nach Anspruch 1, wobei die Sensoreinheit einen oder mehrere Schwingungssensoren und/oder einen oder mehrere akustische Sensoren und/oder einen oder mehrere Magnetometer umfasst.

3. Verfahren nach einem der vorhergehenden Ansprüche, wobei die Niederleistungsmessung einer Betriebszustandsgröße $\omega$ ein Bestimmen ermöglicht, ob die rotierende Maschine läuft oder nicht.

4. Verfahren nach einem der vorhergehenden Ansprüche, wobei die Hochleistungsmessung $\mu(\omega, \tau)$ erfüllt wird, wenn die den laufenden Betriebszustand der rotierenden Maschinen anzeigende Betriebszustandsgröße $\omega$ einen Betriebszustandsschwellenwert überschreitet und/oder die Zeitdauer $\tau$ seit einer vorherigen Hochleistungsmessung einen Zeitschwellenwert überschreitet.

5. Verfahren nach Anspruch 4, wobei mindestens ein aus dem Betriebszustandsschwellenwert und dem Zeitschwellenwert ausgewählter Schwellenwert ein variabler Schwellenwert ist und wobei das Verfahren ein Bestimmen eines Validierungsbetriebszustands basierend auf der Hochleistungsmessbedingung $\mu(\omega, \tau)$ und adaptives Bestimmen des variablen Schwellenwerts basierend auf dem bestimmten Validierungsbetriebszustand umfasst.

6. Verfahren nach einem der vorhergehenden Ansprüche, wobei die Niederleistungsmessung mit einer hohen Wiederholrate wiederholt durchgeführt wird und die Hochleistungsmessbedingung $\mu(\omega, \tau)$ nur dann erfüllt wird, wenn die Zeitdauer $\tau$ seit einer vorherigen Hochleistungsmessung einen Zeitschwellenwert überschreitet, der größer, insbesondere mindestens um einen Faktor von mindestens 2, vorzugsweise von mindestens 5 und mehr bevorzugt von mindestens 10 größer, als eine durchschnittliche Periode der hohen Wiederholrate ist.

7. Verfahren nach Anspruch 4 oder 5, wobei Zeitintervalle zwischen zwei aufeinanderfolgenden Niederleistungsmessungen kleiner als der Zeitschwellenwert sind.

8. Verfahren nach einem der vorhergehenden Ansprüche, wobei die Niederleistungsmessung und/oder die Hochleistungsmessung ferner eine Zeitmessung umfassen und die Niederleistungsmessung und/oder die Hochleistungsmessung zusammen mit einem Zeitstempel basierend auf der Zeitmessung protokolliert werden, wobei das Protokollieren ferner vorzugsweise ein Protokollieren des Betriebszustands der rotierenden Maschine, insbesondere eines laufenden Betriebszustands der rotierenden Maschine, umfasst, um ein Verfolgen von Betriebszustandsänderungen der rotierenden Maschine und/oder ein Überwachen der Alterung der rotierenden Maschine und/oder ein Überwachen von Beanspruchungen der rotierenden Maschine zu ermöglichen, wobei insbesondere ein Protokollieren des Betriebszustands der rotierenden Maschine durchgeführt wird, wenn sich der Betriebszustand der rotierenden Maschine ändert.

9. Verfahren nach einem der vorhergehenden Ansprüche, wobei eine Wartungsbedingung der rotierenden Maschine basierend auf den Überwachungsdaten $\delta$ und/oder der Betriebszustandsgröße $\omega$ bestimmt wird, die bei verschiedenen Hochleistungs- und/oder Niederleistungsmessungen erhalten werden, wobei insbesondere die Überwachungsdaten $\delta$ und/oder die Betriebszustandsgröße $\omega$ Zeitstempel umfassen und eine Gesamtlaufzeit der rotierenden Maschine zumindest teilweise auf den Zeitstempeln basiert.

10. Batteriebetriebene Überwachungsvorrichtung zum Überwachen einer intermittierend laufenden rotierenden Maschine, wobei die Überwachungsvorrichtung umfasst:

   - eine Batterie,
   - eine Sensoreinheit, die von der Batterie gespeist wird,
   - eine Steuereinheit, die von der Batterie gespeist wird,

   wobei die batteriebetriebene Überwachungsvorrichtung so ausgelegt ist, dass sie die intermittierend laufende rotierende Maschine überwacht, indem sie das Verfahren nach einem der Ansprüche 1 bis 9 durchführt.

11. Batteriebetriebene Überwachungsvorrichtung nach Anspruch 10, wobei die batteriebetriebene Überwachungsvorrichtung in die intermittierend laufende rotierende Maschine integriert ist und die batteriebetriebene Überwachungsvorrichtung für eine langfristige Überwachung der intermittierend laufenden rotierenden Maschine ohne Wechseln oder Aufladen der Batterie ausgelegt ist.

12. Batteriebetriebene Überwachungsvorrichtung nach einem der Ansprüche 10 bis 11, ferner umfassend einen Sender oder eine Netzwerkeinheit, der/die zum Senden von Daten, insbesondere Daten, die durch die Niederleistungsmessung und/oder die Hochleistungsmessung erhalten werden, und Zeitstempeln in Bezug auf die Messungen ausgelegt ist, wobei insbesondere die Daten über ein Netzwerk oder einen Kommunikationskanal an einen Computer oder an ein Cloud-Computing-System gesendet werden.

13. Batteriebetriebene Überwachungsvorrichtung nach einem der Ansprüche 10 bis 12, ferner umfassend ein die batteriebetriebene Überwachungsvorrichtung umgebendes Gehäuse, insbesondere ein wasserdichtes und/oder luftdichtes Gehäuse.

14. Batteriebetriebene Überwachungsvorrichtung nach einem der Ansprüche 10 bis 13, ferner dazu ausgelegt, ferngesteuert und in einen Bereitschaftsmodus versetzt zu werden, insbesondere wenn die intermittierend laufende rotierende Maschine für einen längere Zeitperiode nicht läuft.

15. Batteriebetriebene Überwachungsvorrichtung nach einem der Ansprüche 10 bis 14, ferner ausgelegt zum Kommunizieren eines niedrigen Batteriestands.

**Revendications**

1. Procédé (100) de surveillance d'une machine rotative à marche intermittente par un dispositif de surveillance alimenté par batterie, le dispositif de surveillance comprenant une batterie, au moins une unité de capteurs alimentée par la batterie et une unité de commande alimentée par la batterie, le procédé comprenant :

   - la réalisation (102, 204), par l'unité de capteurs, d'une mesure basse puissance d'une quantité d'état de fonctionnement $\omega$ indiquant un état de fonctionnement de la machine rotative ;
   - l'évaluation (104, 206, 208), par l'unité de commande, d'une condition $\mu(\omega, \tau)$ de mesure haute puissance indiquant si une mesure haute puissance doit être réalisée ou non, l'évaluation étant basée sur la quantité d'état de fonctionnement $\omega$ mesurée et sur une durée $\tau$ depuis une mesure haute puissance précédente ; et
   - en cas de respect de la condition $\mu(\omega, \tau)$ de mesure haute puissance évaluée, la réalisation (108, 210), par l'unité de capteurs, de la mesure haute puissance, l'obtention par conséquent de données de surveillance $\delta$ provenant de l'unité de capteurs,

   les étapes de mesure basse puissance et d'évaluation étant réalisées à plusieurs reprises.

**2.** Procédé selon la revendication 1, l'unité de capteurs comprenant un ou plusieurs capteurs de vibrations et/ou un ou plusieurs capteurs acoustiques et/ou un ou plusieurs magnétomètres.

**3.** Procédé selon l'une quelconque des revendications précédentes, la mesure basse puissance d'une quantité d'état de fonctionnement $\omega$ permettant de déterminer si la machine rotative est en marche ou non.

**4.** Procédé selon l'une quelconque des revendications précédentes, la condition $\mu(\omega, \tau)$ de mesure haute puissance étant remplie lorsque la quantité d'état de fonctionnement $\omega$ indiquant l'état de fonctionnement en marche de la machine rotative dépasse un seuil d'état de fonctionnement et/ou que la durée $\tau$ depuis une mesure haute puissance précédente dépasse un seuil de temps.

**5.** Procédé selon la revendication 4, au moins un seuil sélectionné parmi le seuil d'état de fonctionnement et le seuil de temps étant un seuil variable, et le procédé comprenant la détermination d'un état de fonctionnement de validation sur la base de la condition $\mu(\omega, \tau)$ de mesure haute puissance, et la détermination adaptative du seuil variable sur la base de l'état de fonctionnement de validation déterminé.

**6.** Procédé selon l'une quelconque des revendications précédentes, la mesure basse puissance étant réalisée à plusieurs reprises à une vitesse de répétition élevée et la condition $\mu(\omega, \tau)$ de mesure haute puissance étant remplie uniquement lorsque la durée $\tau$ depuis une mesure haute puissance précédente dépasse un seuil de temps qui est supérieur à une période moyenne de la vitesse de répétition élevée, en particulier au moins supérieur d'un facteur d'au moins 2, de préférence d'au moins 5, plus préférablement d'au moins 10.

**7.** Procédé selon la revendication 4 ou la revendication 5, des intervalles de temps entre deux mesures basse puissance consécutives étant inférieurs au seuil de temps.

**8.** Procédé selon l'une quelconque des revendications précédentes, la mesure basse puissance et/ou la mesure haute puissance comprenant en outre une mesure de temps et la mesure basse puissance et/ou la mesure haute puissance étant enregistrées ensemble avec un horodatage sur la base de la mesure de temps, l'enregistrement comprenant de préférence en outre un enregistrement de l'état de fonctionnement de la machine rotative, en particulier d'un état de fonctionnement en marche de la machine rotative pour permettre un suivi de changements d'état de fonctionnement de la machine rotative et/ou une surveillance du vieillissement de la machine rotative et/ou une surveillance de contraintes de la machine rotative, en particulier un enregistrement de l'état de fonctionnement de la machine rotative étant réalisé lorsque l'état de fonctionnement de la machine rotative change.

**9.** Procédé selon l'une quelconque des revendications précédentes, une condition de maintenance de la machine rotative étant déterminée sur la base des données de surveillance $\delta$ et/ou de la quantité d'état de fonctionnement $\omega$ obtenues pendant différentes mesures haute puissance et/ou basse puissance, en particulier les données de surveillance $\delta$ et/ou la quantité d'état de fonctionnement $\omega$ comportant des horodatages et un temps en marche total de la machine rotative étant déterminé sur la base au moins en partie des horodatages.

**10.** Dispositif de surveillance alimenté par batterie pour la surveillance d'une machine rotative à marche intermittente, le dispositif de surveillance comprenant :

- une batterie,
- une unité de capteurs alimentée par la batterie,
- une unité de commande alimentée par la batterie ;

le dispositif de surveillance alimenté par batterie étant configuré pour surveiller la machine rotative à marche intermittente en mettant en œuvre le procédé selon l'une quelconque des revendications 1 à 9.

**11.** Dispositif de surveillance alimenté par batterie selon la revendication 10, le dispositif de surveillance alimenté par batterie étant intégré à la machine rotative à marche intermittente et le dispositif de surveillance alimenté par batterie étant configuré pour une surveillance long terme de la machine rotative à marche intermittente sans remplacement ou recharge de batterie.

**12.** Dispositif de surveillance alimenté par batterie selon l'une quelconque des revendications 10 à 11, comprenant en outre un envoyeur ou une unité réseau configuré(e) pour émettre des données, en particulier des données obtenues par la mesure basse puissance et/ou la mesure haute puissance et/ou des horodatages liés aux mesures, en particulier, les données étant émises sur un réseau ou un canal de communication vers un ordinateur ou un système informatique en infonuage.

**13.** Dispositif de surveillance alimenté par batterie selon l'une quelconque des revendications 10 à 12, comprenant en outre un boitier renfermant le dispositif de surveillance alimenté par batterie, en particulier un boitier étanche à l'eau et/ou étanche à l'air.

**14.** Dispositif de surveillance alimenté par batterie selon l'une quelconque des revendications 10 à 13, en outre configuré pour être commandé à distance et mis dans un mode en veille, en particulier lorsque la machine rotative à marche intermittente n'est pas en marche pendant une période de temps prolongée.

**15.** Dispositif de surveillance alimenté par batterie selon l'une quelconque des revendications 10 à 14, en outre configuré pour communiquer une condition de batterie faible.

100

102

104

108

FIG 1

FIG 2

FIG 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018189602 A1
- WO 2020168379 A1
- US 6124692 A